# EUROPÄISCHE PATENTSCHRIFT

(11) **EP 2 356 711 B1**
(45) Veröffentlichungstag und Bekanntmachung des Hinweises auf die Patenterteilung: **10.06.2020**
(21) Anmeldenummer: 09784011.0
(22) Anmeldetag: 14.10.2009
(51) Int. Cl.: H01L 51/52, H01L 51/56

(54) **ORGANISCHE LEUCHTDIODE MIT OPTISCHEM RESONATOR NEBST HERSTELLUNGSVERFAHREN**
ORGANIC LIGHT-EMITTING DIODE HAVING OPTICAL RESONATOR IN ADDITION TO PRODUCTION METHOD
DIODE ÉLECTROLUMINESCENTE ORGANIQUE AVEC RÉSONATEUR OPTIQUE, AINSI QUE PROCÉDÉ DE FABRICATION

(30) Priorität: 09.12.2008 DE 102008054435
(43) Veröffentlichungstag der Anmeldung: 17.08.2011
(73) Patentinhaber: Universität zu Köln, 50923 Köln (DE)
(72) Erfinder: GATHER, Malte, 52064 Aachen (DE); MEERHOLZ, Klaus, 51503 Roesrath (DE)
(74) Vertreter: Gille Hrabal
(86) Internationale Anmeldenummer: PCT/EP2009/063422
(87) Internationale Veröffentlichungsnummer: WO 2010/066488

(56) Entgegenhaltungen:
- WO-A-2006/087658
- US-A1- 2007 159 086
- US-A1- 2008 074 037
- US-A1- 2008 197 371
- US-A1- 2008 268 135

## Beschreibung

Die Erfindung betrifft organische Leuchtdioden, bekannt unter der Abkürzung OLED, sowie ein Verfahren für die Herstellung von solchen organischen Leuchtdioden.

Eine organische Leuchtdiode ist ein leuchtendes, aus organischen Halbleitern bestehendes Bauelement. Organische Leuchtdioden bestehen aus einer oder mehreren organischen, dünnen Schichten, die zwischen elektrisch leitfähigen Elektroden angeordnet sind.

Eine organische Leuchtdiode umfasst eine beispielsweise auf einer Glasscheibe aufgebrachte Anode, die z. B. aus Indium-Zinn-Oxid (ITO) besteht, und die im sichtbaren Bereich transparent ist. Oberhalb der Anode befindet sich häufig eine Lochleitungsschicht. Diese Lochleitungsschicht kann beispielsweise aus PEDOT/PSS (Poly(3,4-ethylendioxythiophen)/ Polystyrolsulfonat) bestehen, die der Absenkung der Injektionsbarriere für die Löcher und als Diffusionsbarriere für Indium dient. Auf der Lochleitungsschicht wird eine Emitterschicht vorgesehen, die entweder einen Farbstoff enthält (ca. 5-10 %) oder vollständig aus dem Farbstoff (z. B. Aluminium-tris(8-hydroxychinolin), Alq₃) besteht. Auf dieser ist häufig eine Elektronenleitungsschicht aufgebracht. Zum Abschluss wird eine Kathode mit geringer Elektronenaustrittsarbeit, bestehend aus einem Metall oder einer Legierung wie zum Beispiel Calcium, Aluminium, Barium, Ruthenium, Magnesium-Silber-Legierung, beispielsweise im Hochvakuum aufgedampft. Zur Verringerung der Injektionsbarriere für Elektronen wird die Kathode regelmäßig als Doppelschicht bestehend aus einer sehr dünnen Schicht aus Lithiumfluorid, Cäsiumfluorid, Calcium oder Barium und einer dickeren Schicht aus Aluminium oder Silber aufgedampft.

Für organische Leuchtdioden sind Kathodenschichten mit einer Mehrlagenstruktur wie Lithiumfluorid/Kalzium/Aluminium oder Barium/Silber aus der EP 1083612 A2 bekannt. Die Funktion des Lithiumfluorids bzw. des Kalziums bzw. des Bariums besteht darin, Elektronen in die darunter liegende Schicht zu injizieren. Die Dicke der Lithiumfluoridschicht beträgt wenige Nanometer. Die Dicke der Barium- bzw. der Kalziumschicht kann bis zu 100 nm betragen. Die Funktion der Aluminium- oder Silberschicht besteht darin, den Hauptteil der Ladungen vom Kathodenanschluß zum lichtemittierenden Element, d.h. zur lichtemittierenden Schicht zu transportieren. Die Dicke dieser Schicht liegt im Bereich von 0,1 bis 2 *µ*m. Dabei bildet die Schicht aus Lithiumfluorid, Kalzium oder Barium die sog. Elektroneninjektionsschicht, die Aluminium-/ Silberschicht die elektrisch leitende Schicht der Kathode. Zusätzlich schützt die Aluminium- bzw. Silberschicht die noch empfindliche und reaktive Elektroneninjektionsschicht.

Die Elektronen, also die negativen Ladungen werden von der Kathode injiziert, während die Anode die Löcher bzw. Defektelektronen, also die positiven Ladungen bereitstellt. Positive und negative Ladungen wandern aufgrund eines angelegten elektrischen Feldes aufeinander zu und treffen sich im Idealfall in der Emitterschicht, weshalb diese Schicht auch Rekombinationsschicht genannt wird. Durch Rekombination eines Elektrons und eines Loches in der Emitterschicht entsteht ein sogenanntes Exziton. Abhängig vom Mechanismus stellt das Exziton bereits den angeregten Zustand des Farbstoffmoleküls dar, oder aber die Energie des Exzitons wird in einem Transferprozess auf das Farbstoffmolekül übertragen. Der Farbstoff hat verschiedene Anregungszustände. Der angeregte Zustand kann in den Grundzustand übergehen und dabei ein Photon (Lichtteilchen) aussenden. Die Farbe des ausgesendeten Lichts hängt vom Energieabstand zwischen angeregtem und Grundzustand ab und kann durch Variation oder chemische Modifikation der Farbstoffmoleküle gezielt verändert werden.

Organische Leuchtdioden werden vor allem in Displays für Computer, Fernseher, MP3-Player usw. eingesetzt oder aber als Lichtquelle in Beleuchtungsanwendungen. OLEDs kommen zunehmend auch als Lichtquellen für Anwendungen in der Sensorik in Betracht.

Sollen organische Leuchtdioden in Vollfarb-Displays eingesetzt werden, so setzt dies voraus, dass zumindest drei Grundfarben unabhängig voneinander gesteuert erzeugt werden können. Das Display umfasst dann eine Vielzahl von einzelnen Pixeln bzw. organischen Leuchtdioden, die verschiedenfarbiges Licht emittieren können, wobei die Erzeugung von Licht durch ein jedes Pixel elektronisch gesteuert werden kann.

Soll eine organische Leuchtdiode als Lichtquelle zur Beleuchtung eingesetzt werden, so ist eine elektronische Ansteuerung einzelner Pixel nicht erforderlich. Eine Lichtquelle kann zwar ebenfalls eine Vielzahl von Pixeln bzw. organischen Leuchtdioden, die unterschiedliche Lichtfarben erzeugen können, umfassen. Diese Aufteilung dient jedoch lediglich dazu, die gewünschte Lichtfarbe erzeugen zu können, so zum Beispiel weißes Licht, indem die Pixel die drei Grundfarben Rot, Grün und Blau geeignet verteilt ausstrahlen.

Sollen organische Leuchtdioden in der Sensorik eingesetzt werden, hängt es von der jeweiligen Anwendung ab, ob verschiedenfarbig emittierende, einzeln ansteuerbare Pixel benötigt werden oder nicht. Aufgrund der im Vergleich zu anderen in der Sensorik verwendeten Lichtquellen (z.B. LEDs) - spektral breiten Emission der meisten aus dem Stand der Technik bekannten organischen Leuchtdioden ist die Verwendung verschiedenfarbig emittierender Pixel mit den Stand der Technik häufig nicht sinnvoll möglich.

Aus dem Stand der Technik ist bekannt, die einzelnen Pixel eines Displays oder einer Lichtquelle auf Basis organischer Leuchtdioden im Hochvakuum durch thermische Verdampfung von verschiedenfarbig emittierenden kleinen Molekülen herzustellen. In diesem mindestens dreistufigen Prozess werden beispielsweise rot, grün und blau emittierende kleine Moleküle nacheinander durch Schattenmasken auf das Substrat aufgebracht. Bei diesem Verfahren werden grundsätzlich kleine Moleküle und nicht etwa Polymere abgeschieden, da Polymere zu groß sind, um sich thermisch verdampfen zu lassen.

Ein typisches kleines Molekül, welches durch thermische Verdampfung aufgetragen wird, ist der Metallkomplex Alq₃, Alq₃ emittiert grünes Licht. Durch Beimischung von Farbstoffen kann die Emissionsfarbe von Alq₃ verändert werden. Darüber hinaus können auch andere Metallkomplexe oder andere kleine Moleküle verwendet werden, um andere Farben zu erzeugen, die durch Alq₃ oder modifiziertes Alq₃ nicht zu erreichen sind.

Thermische Verdampfung wird bevorzugt, da keine Lösungsmittel verwendet werden müssen, obwohl die Durchführung eines solchen Verfahrens teuer ist. Wird ein Lösungsmittel verwendet, so besteht die Gefahr der Verunreinigung des Materials mit negativem Einfluss auf die Effizienz einer organische Leuchtdiode und ihrer Lebensdauer.

Eine Schattenmaske, die für die beschriebene Strukturierung verwendet wird, gleicht einem Lochsieb. Die Schattenmaske weist Öffnungen an den Stellen auf, zu denen das jeweilige Molekül auf ein darunter befindliches Substrat gelangen soll. Nach einer ersten Abscheidung von ersten Molekülen durch die Öffnungen der Schattenmaske hindurch wird die Schattenmaske geeignet verschoben oder durch eine zweite Schattenmaske ausgetauscht, und es werden zweiten Moleküle, die eine andere Lichtfarbe emittieren, durch die Löcher der Schattenmaske hindurch auf dem darunter befindlichen Substrat abgeschieden. In gleicher Weise werden in einem dritten Schritt dritte Moleküle abgeschieden.

Die korrekte Ausrichtung der Schattenmasken relativ zueinander und relativ zum Substrat hat sich als schwierig erwiesen, da über große Flächen Ausrichtungsgenauigkeiten in der Größenordnung von 1 bis 10 *µ*m erforderlich sind [Stephen R. Forrest, Nature 428, S. 911-91 8 (2004)]. Ein weiteres Problem besteht darin, dass sich die Moleküle während des Abscheidens nicht nur auf dem Substrat absetzen, sondern auch nacheilhaft auf der Schattenmaske. Diese Abscheidung führt zu einer Veränderung der Löcher der Schattenmaske und damit zu einer Veränderung der Abscheidungen auf dem Substrat. Außerdem können die abgeschiedenen Substanzen sich von der Schattenmaske ablösen, was zur Staubbildung führt. Die Staubbildung beeinträchtigt nachteilhaft die Herstellung von OLEDs.

Aus der Druckschrift "Solution-Processed Full-Color Polymer Organic Light-Emitting Diode Displays Fabricated by Direct Photolithography" by Malte C. Gather, Anne Köhnen et al. aus Advanced Functional Materials, 2007, 17, 191-200 ist ein alternatives photolithographisches Verfahren bekannt, um verschiedenfarbig emittierende organische Leuchtdioden als Pixel eines Displays in beschriebener Weise herzustellen. Hier werden die emittierenden Materialien - in diesem Fall elektrolumineszierende Polymere - aus Lösung abgeschieden, so dass auf den Kosten intensiven thermischen Verdampfungsschritt im Hochvakuum verzichtet werden kann. Allerdings sind auch hier drei aufeinander folgende Ausrichtungsschritte erforderlich, um rot, grün und blau emittierende Pixel herzustellen.

Um den komplizierten Ausrichtungsvorgang zu umgehen, wurde zudem vorgeschlagen, statt der strukturierten Aufbringung verschiedenfarbig emittierender kleiner Moleküle oder Polymere eine Materialmischung oder einen Mehrschichtaufbau zu verwenden, die/ der weißes Licht emittiert und diese/ diesen für alle Subpixel zu verwenden. Geeignete Materialmischungen/ Mehrschichtaufbauten können aus Polymeren oder aus kleinen Molekülen wie z. B. Metallkomplexen bestehen. Im letzteren Fall werden Metallkomplexe häufig bevorzugt, da diese derzeit eine größere Helligkeit ermöglichen. In der Regel umfasst eine solche Materialmischung bzw. ein solcher Mehrschichtaufbau Komponenten, die die drei Grundfarben emittieren und so schließlich weißes Licht ausstrahlen.

Der Farbeindruck wird durch die nachträgliche Auflaminierung einer Matrix von Farbfiltern erreicht. Eine solche Matrix bzw. ein solches Farbfilterarray wird aus eingefärbten Fotolacken hergestellt. Zunächst wird zur Herstellung eine erste Fotolackschicht aufgetragen, die beispielsweise als Farbfilter für blaues Licht dient. Diese Fotolackschicht wird an den entsprechenden Stellen belichtet und so unlöslich gemacht. Die übrigen, unbelichteten Bereiche werden abgewaschen. Anschließend wird ein nächster Fotolack aufgetragen, der einen anderen Farbfilter bildet. In mindestens drei Stufen wird so die gewünschte Matrix von Farbfiltern erhalten. Ein solcher Stand der Technik ist z. B. den Druckschriften "I Underwood et al., SID 04 Digest, S. 293-295 (2004)" sowie "B. J. Green, Displays 10(3), S. 181-1 84 (1989)" zu entnehmen.

Hierdurch verlagert sich das Ausrichtungsproblem jedoch lediglich auf einen späteren Zeitpunkt der Prozesskette, da die Farbfilter bzw. das Farbfilterarray relativ zur Subpixelstruktur exakt ausgerichtet werden muss. Außerdem sind die mit diesem Verfahren erreichten Farbsättigungen und Leistungseffizienz für viele Anwendungen unzureichend.

Aus der Druckschrift US 2007/0286944 A1 ist eine organische Leuchtdiode bekannt, die einen verlustbehafteten optischen Resonator umfasst. Zwischen einer vollständig reflektierenden Kathodenschicht und einer teilweise reflektierenden Anodenschicht befindet sich ein Schichtsystem bestehend aus einer Lochinjektionsschicht, einer Lochtransportschicht, einer Emitterschicht und einer Elektronentransportschicht. Die Lichtfarbe, die von dieser organischen Leuchtdiode erzeugt wird, wird durch den Abstand zwischen den beiden reflektierenden Elektrodenschichten eingestellt. Um unterschiedliche Lichtfarben zu erzeugen, wird die Dicke der Lochinjektionsschicht variiert. Die verschiedenen Schichten werden aufgedampft. Um die Dicke der Lochinjektionsschicht einzustellen, werden kleine Moleküle in unterschiedlichen Dicken aufgedampft. Um drei unterschiedliche Schichtdicken definiert herzustellen, ist es während des Aufdampfens erforderlich, Lochmasken zu verwenden und entsprechend auszurichten. Dieser Stand der Technik weist daher die bereits oben genannten Nachteile auf, nämlich komplizierte Ausrichtungen mehrfach vornehmen zu müssen.

Aus der Druckschrift US 6,091,197 geht ebenfalls eine organische Leuchtdiode mit einem verlustbehafteten optischen Resonator hervor, in dem eine Schicht angeordnet ist, die weißes Licht zu erzeugen vermag. Der Abstand der beiden spiegelnden Schichten des optischen Resonators bestimmt die Lichtfarbe, die aus der organischen Leuchtdiode austritt. Dieser Abstand kann mittels einer elektromechanischen Ansteuerung verändert werden, um so die Lichtfarbe der organischen Leuchtdiode verändern zu können. Der aus der Druckschrift US 6,091,197 bekannte Stand der Technik eignet sich zwar für die Herstellung einer Lichtquelle, bei der eine gewünschte Lichtfarbe eingestellt und jederzeit verändert werden kann. Für weitere Anwendungsfälle ist die hieraus bekannte Erfindung aber ungeeignet. So eignet sich der Gegenstand nicht für eine Verwendung als Display, da ständig ein elektrisches Feld angelegt werden muss, um eine gewünschte Emissionsfarbe einzuhalten. Die Herstellung und Anordnung der flexiblen Membran ist relativ aufwendig, so dass die Schaffung einer kostengünstigen Weißlichtquelle, einer Lichtquelle für sensorische Anwendungen, die Licht verschiedener Farben emittiert, oder eines Spektrometers mit diesem Gegenstand ebenfalls nicht möglich ist.

Aus der Druckschrift DE 100 37 391 A1 sind vernetzbare, organische Materialien bekannt, die in organischen Leuchtdioden verwendet werden sollen.

Die Druckschrift US 2007/0159086 A1 offenbart eine organische Leuchtdiode mit einem optischen Resonator und eine Licht emittierende Schicht im optischen Resonator. Durch unterschiedliche Weglängen für das Licht werden unterschiedliche Lichtfarben erzeugt. Die unterschiedlichen Weglängen werden durch voneinander getrennte Lochinjektionsschichten erhalten, die unterschiedlich dick sind.

Die Druckschrift US 2008/0074037 A1 offenbart eine organische Leuchtdiode mit einer Anode, einer Kathode, einer dazwischen befindlichen Loch leitenden Schicht sowie einer dazwischen befindlichen Licht emittierenden Schicht mit unterschiedlich dicken, räumlich voneinander getrennten Schichten, um so in Abhängigkeit von Lichtfarben Lochinjektionen optimieren zu können. Unterschiedliche Schichtdicken werden durch unterschiedliche Bestrahlungen von vernetzbarem Material mit ultraviolettem Licht erhalten. US 2008/268135 offenbart eine OLED mit einer photochemisch vernetzbaren Emitterschicht. WO 2006/087658 offenbart eine OLED mit einer Weißlicht emittierenden Emitterschicht und einer Lochtransportschicht mit variierender Schichtdicke.

Aufgabe der Erfindung ist die Schaffung einer einfacher herzustellenden organischen Leuchtdiode.

Die Aufgabe wird durch eine organische Leuchtdiode mit den Merkmalen des Anspruchs 1 sowie durch ein Verfahren mit den Merkmalen des nebengeordneten Anspruchs gelöst.

Erfindungsgemäß wird eine OLED bzw. organische Leuchtdiode mit einer Emitterschicht hergestellt, die insbesondere weißes Licht emittiert. Die Emitterschicht wird innerhalb eines verlustbehafteten, optischen Resonators angeordnet. Ein optischer Resonator ist eine Anordnung von zwei spiegelnden bzw. reflektierenden Schichten, die dazu dient, Licht hin und her zu reflektieren. Im Resonator bildet sich eine stehende Welle aus, wenn die optische Weglänge des Resonators ein Vielfaches der Wellenlänge des emittierten Lichts beträgt. Im Unterschied zu einem verlustfreien Resonator kann ein Lichtstrahl aus einem verlustbehafteten Resonator nach einigen Reflexionen aus der Anordnung entkommen. Eine reflektierende Schicht des Resonators reflektiert nur teilweise und ist darüber hinaus für Licht teilweise durchlässig, so dass Licht über diese teilweise reflektierende bzw. teilweise spiegelnde Schicht ausgekoppelt wird. Die andere reflektierende Schicht des verlustbehafteten optischen Resonators reflektiert Licht bevorzugt möglichst vollständig, um zu guten Wirkungsgraden zu gelangen.

Die optische Weglänge zwischen den beiden reflektierenden Schichten des Resonators bestimmt die Farbe des aus dem optischen Resonator und damit aus der Leuchtdiode austretenden Lichts. Die Farbe des aus der Leuchtdiode austretenden Lichts wird also durch Abstände eingestellt. Um eine Vielzahl von Farben erzeugen zu können, müssen unterschiedliche optische Weglängen zwischen den beiden spiegelnden Flächen vorhanden sein, wie beispielsweise den Druckschriften US 6,091,197 sowie US 2007/0286944 A1 zu entnehmen ist. Die entsprechenden unterschiedlichen Abstände können im Unterschied zum Stand der Technik erfindungsgemäß in nur einem Arbeitsschritt durch ein fotolithografisches Verfahren hergestellt werden. Es resultiert eine organische Leuchtdiode mit einem verlustbehafteten optischen Resonator, in dem sich eine Emitterschicht sowie eine Schicht befindet, die fotolithographisch strukturiert werden kann. Diese aus photochemisch vernetzbaren Materialien bestehende Schicht weist unterschiedliche Schichtdicken auf, um so unterschiedliche optische Weglängen bereitzustellen. Die Schicht besteht aus photochemisch vernetzbaren, elektrisch leitenden oder halbleitenden Materialien. Diese elektrisch leitenden oder halbleitenden Negativ - Fotolacke werden bei Belichtung ganz oder teilweise unlöslich. Die nicht belichteten Bereiche bleiben löslich. Auch vergleichbar wirkende Materialien können verwendet werden. Als Material kommt also beispielsweise auch ein elektrisch leitender oder halbleitender Positiv-Photolack in Betracht, der durch Belichtung ganz oder teilweise löslich wird. Die nicht belichteten Bereiche bleiben hier also unlöslich.

Die Lichtfarbe des aus der organischen Leuchtdiode austretenden Lichts wird durch die Ausbildung der stehenden Wellen im verlustbehafteten optischen Resonator bestimmt. Es treten zwar auch andere Lichtwellenlängen aus. Allerdings kann bei Bedarf aufgrund des Resonators die entsprechende, gewünschte Farbe so verstärkt werden, dass die entsprechende Wellenlänge bei weitem überwiegt. Die reflektierenden Schichten des optischen Resonators bestehen der Einfachheit halber aus Metall. Grundsätzlich kommen auch andere Materialien in Betracht, beispielsweise dielektrische Schichtstapel, die im Zusammenhang mit Bragg-Spiegeln vorgesehen werden.

Eine spiegelnde Schicht des optischen Resonators besteht insbesondere aus Ag, Al, Au, oder es handelt sich um ein oder mehrere Bragg-Spiegel. Im Fall von Bragg-Reflexionen werden in der Regel mehrere, übereinander gestapelte Bragg-Spiegel vorgesehen, um das gesamte Lichtspektrum zu reflektieren. Soll eine reflektierende Schicht teilweise transparent sein, so wird die Schichtdicke geeignet dünn gewählt, so eine beispielsweise 10 bis 100 nm dünne, aus Silber, Aluminium, Gold, Kupfer, Titan oder Nickel bestehende Schicht.

Zwar kann grundsätzlich die Emitterschicht, also die Schicht, die Licht emittiert, unterschiedlich dick sein und aus einem photochemisch vernetzbaren Material bestehen. Hierdurch wird jedoch die Materialauswahl stark eingeschränkt, aus der die Emitterschicht bestehen kann.

Erfindungsgemäß umfasst die organische Leuchtdiode innerhalb des optischen Resonators eine zusätzliche Schicht (zusätzlich zur Emitterschicht), nämlich eine Lochleiterschicht mit sich verändernder Dicke, die aus dem photochemisch vernetzbaren Material besteht. Die Emitterschicht kann nun aus nicht photochemisch vernetzbarem Material bestehen. Das Material der Emitterschicht kann daher entsprechend freier gewählt und die Emitterschicht einfacher hinsichtlich der Lichterzeugung optimiert werden.

Eine Emitterschicht wird vorzugsweise durch ein RGB-Copolymer gebildet. Ein RGB-Copolymer emittiert wenigstens rotes, grünes und blaues Licht. Die Emitterschicht kann eine Mischung aus rot, grün und blau emittierenden Komponenten sein oder ein Schichtsystem, das eine rotes Licht emittierende Schicht, eine grünes Licht emittierende Schicht und eine blaues Licht emittierende Schicht umfasst.

Da die Schicht, die strukturiert wird, also unterschiedlich dick hergestellt wird, photochemisch vernetzt werden kann, ist eine fotolithographische Strukturierung möglich. Das Grundprinzip der Photolithographie wird beispielsweise in der Druckschrift "Adams, Layton, Siahmakoun, "Lecture Notes in Computer Science, Springer-Verlag (2008)" beschrieben. Die Strukturierung photochemisch vernetzbarer Halbleiter geht aus der Druckschrift "Gather et al., Solution-Processed Full-Color Polymer Organic Light-Emitting Diode Displays Fabricated by Direct Photolithography, Advanced Functional Materials, 17, 191-200, 2007" hervor.

Im Unterschied zu den vorgenannten Druckschriften erfolgt die Strukturierung erfindungsgemäß nicht mit Hilfe einer Schwarz-Weiß Schattenmaske sondern mit Hilfe einer Graustufenmaske, also einer Maske, die an verschiedenen Stellen unterschiedliche Lichtdurchlässigkeit aufweist. Dies ermöglicht es, ortsaufgelöst unterschiedliche Belichtungsdosen anzuwenden. Die Graustufenmaske kann eine Glasplatte sein, die mit metallischen Schichten unterschiedlicher Schichtdicke beschichtet ist. Licht, welches auf die Glasplatte auftrifft, wird unterschiedlich stark absorbiert. Es kann sich aber beispielsweise auch um eine PET-Folie, also eine aus Polyethylenterephthalat bestehende Folie handeln, die unterschiedlich stark auf der Oberfläche geschwärzt ist und so Licht unterschiedlich gut durchlässt.

Eine solche Schatten- bzw. Graustufenmaske wird auf die Schicht gelegt, die sich fotolithographisch strukturieren, also zum Beispiel photochemisch vernetzen lässt. Anschließend wird durch die Schattenmaske hindurch belichtet. Hierdurch wird erreicht, dass die photochemisch vernetzbare Schicht unterschiedlich stark vernetzt wird. Dies führt zu unterschiedlichen Schichtdicken bei der Schicht, die unterschiedlich stark vernetzt wurde. Durch das Vernetzen wird insbesondere erreicht, dass die Schicht in den vernetzten Bereichen unlöslich wird. Darüber hinaus bleibt die Schicht löslich. Regelmäßig wird nach dem Vernetzen ein Entwicklungsschritt durchgeführt, um die nicht vernetzten Bestandteile zu entfernen. Auf diese Weise wird in nur einem Arbeitsschritt die gewünschte Strukturierung erreicht. Eine mehrfache Ausrichtung - wie eingangs beschrieben - entfällt.

Soll die Leuchtdiode als Lichtquelle eingesetzt werden, so kann die zusätzliche Schicht elektrisch leitfähig sein. Soll das erfindungsgemäße Verfahren zur Herstellung von Displays dienen, so muss eine unterschiedliche Ansteuerung der Pixel möglich sein. Dies ist möglich, wenn die zusätzliche Schicht aus einem halbleitenden Material bzw. einem Material mit hinreichend geringer elektrischer Leitfähigkeit besteht.

In einer Ausführungsform werden niedermolekulare, vernetzbare Lochleiter als Material der zusätzlichen Schicht vorgesehen, so zum Beispiel die nachfolgend gezeigte Struktur auf der Basis von Triarylamin mit Oxetan als reaktiver Gruppe:

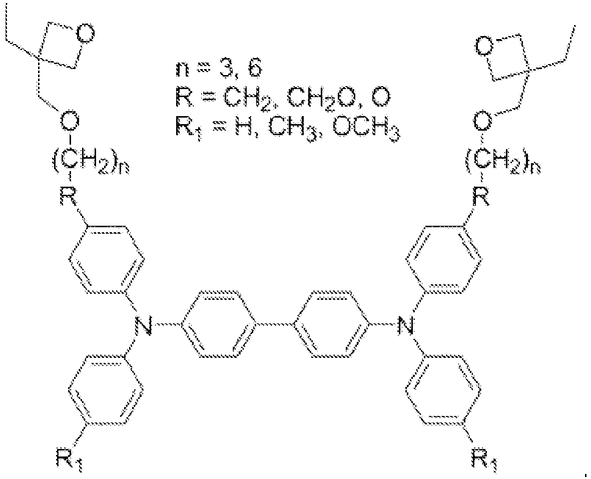

Weitere Beispiele für geeignete Materialien ergeben sich aus den nachfolgenden Strukturen:

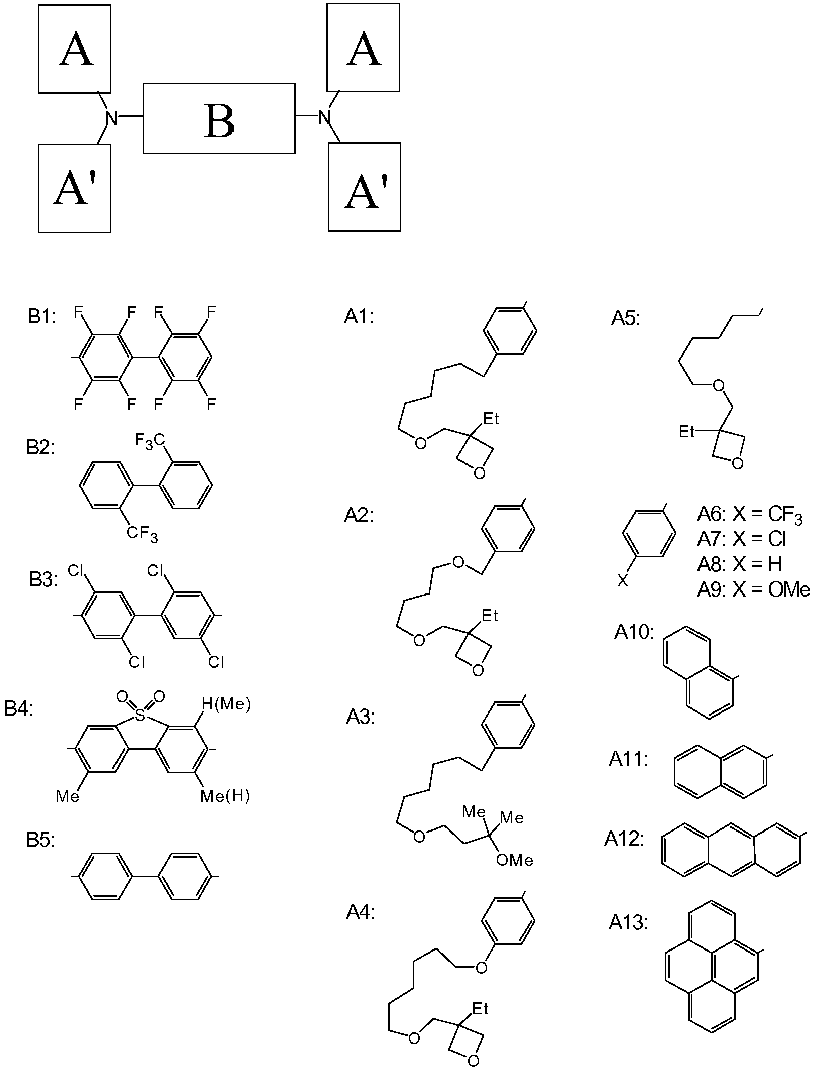

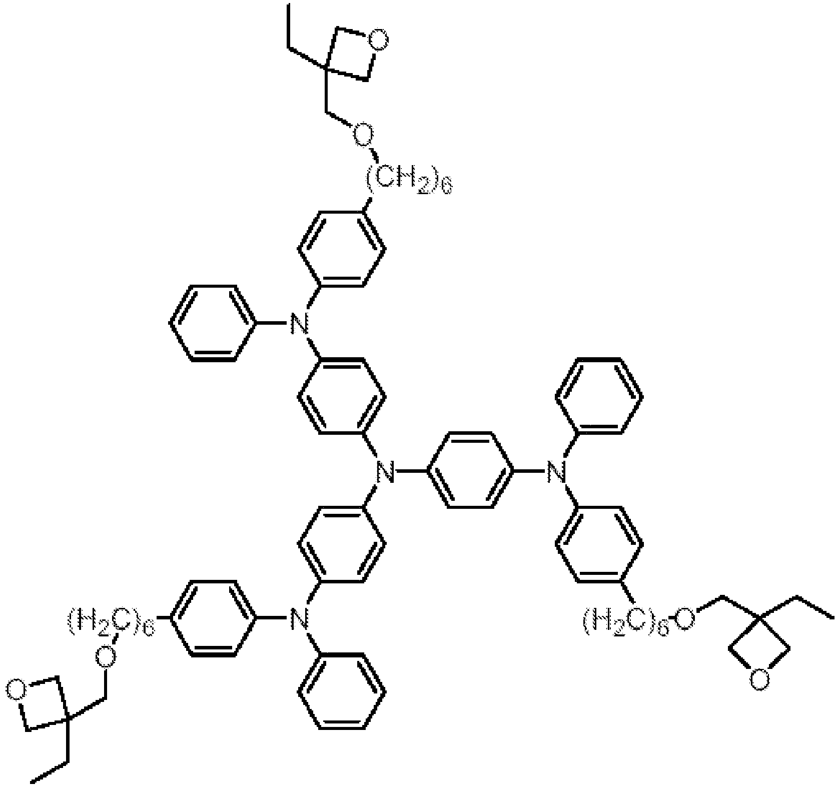

Weitere mögliche chemische Strukturen, die nicht zur Erfindung gehören, werden nachfolgend abgebildet.

Diese sind ebenfalls photochemisch vernetzbar, basieren aber nicht auf Oxetanen. Beispielsweise können Derivate der Zimtsäure verwendet werden, die durch eine [2+2]Cycloaddition vernetzen. Die chemischen Strukturen solcher Materialien sind im folgenden gezeigt:

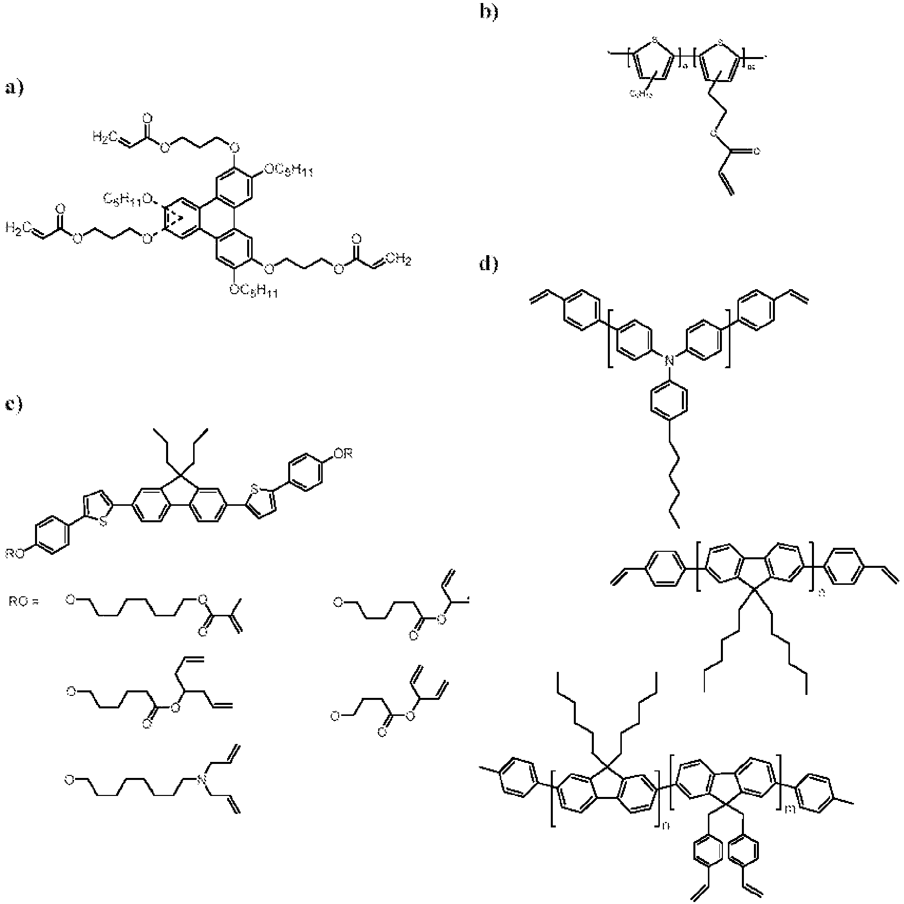

Außerdem können Diene und Methacrylate zur photoinduzierten radikalischen Vernetzung verwendet werden. Die chemischen Strukturen solcher Materialien sind im folgenden gezeigt.

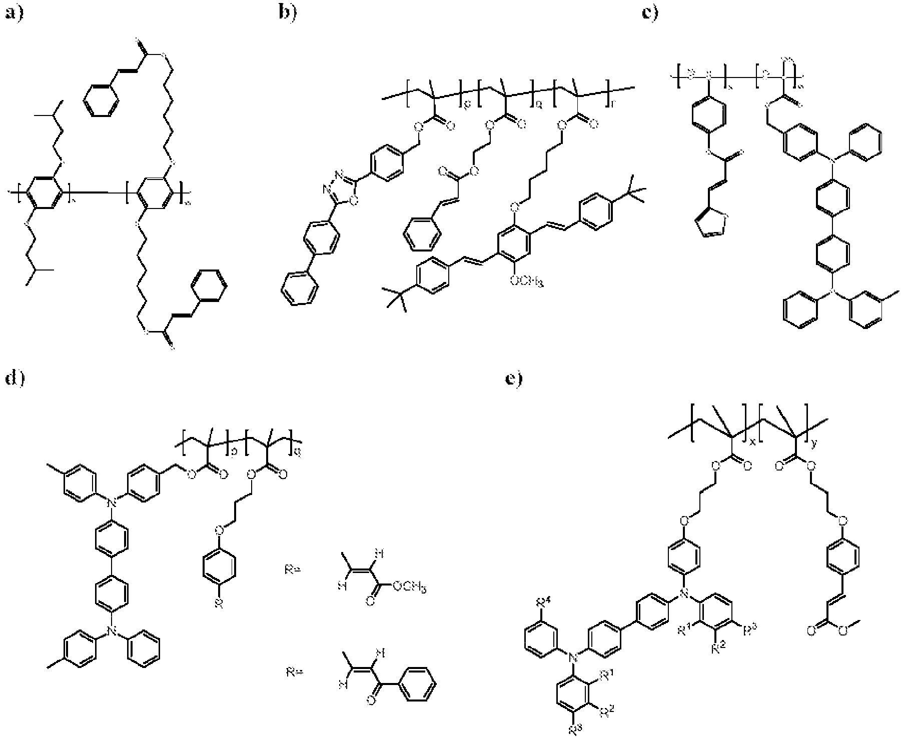

In einer anderen Ausführungsform der Erfindung werden vernetzbare, oligomere oder polymere Lochleitermaterialien als Material der zusätzlichen Schicht vorgesehen, da so Produktionsbedingungen im Vergleich zu den niedermolekularen, vernetzbaren Lochleitern vereinfacht werden können. Ursächlich dafür sind die guten Filmbildungseigenschaften von oligomeren oder polymeren Lochleitermaterialien.

Nachfolgend wird die chemische Struktur von oligomeren, vernetzbaren Lochleitern auf der Basis von Triarylamin mit Oxetan als reaktiver Gruppe gezeigt.

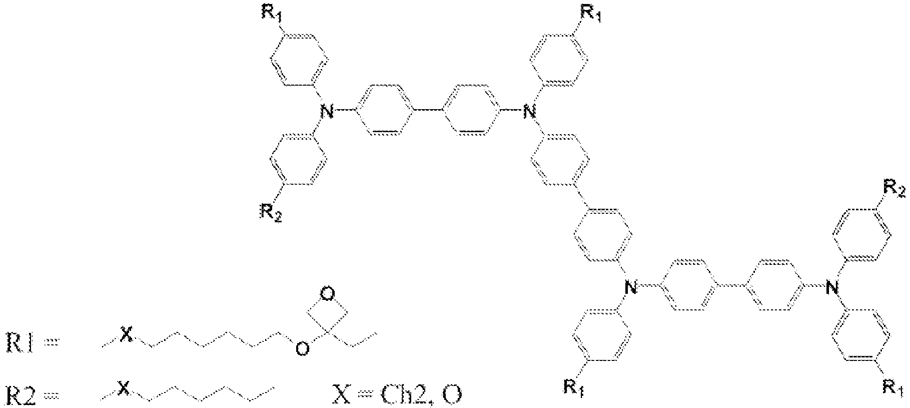

Nachfolgend wird die chemische Struktur von polymeren, vernetzbaren Lochleitern auf der Basis von Triarylamin mit Oxetan als reaktiver Gruppe gezeigt.

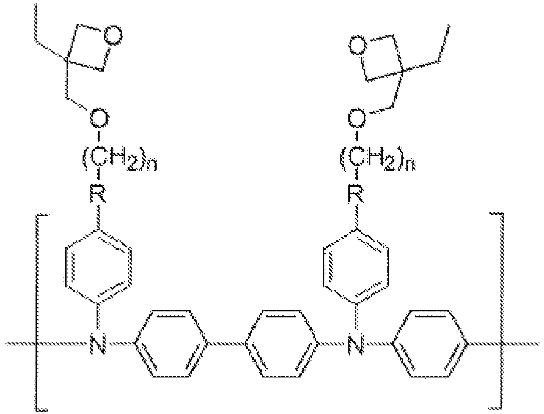

Mit der vorliegenden Erfindung lässt sich ein gewünschter Farbton sehr genau einstellen. Die Emitterschicht, die vorzugsweise weißes Licht erzeugt, kann aus Polymeren, Oligomeren, kleinen Molekülen, Metallkomplexen oder Mischungen davon bestehen.

Ein OLED-Aufbau der vorliegenden Erfindung umfasst insbesondere mehrere dünne, organische Schichten. Es kann oberhalb einer für Licht ganz oder teilweise transparenten Anode (z.B. Indium-Zinn-Oxid, ITO vom englischen Indium-Tin-Oxide, Silber, Aluminium, Gold, MoO₃, Nickel, TiN), die sich auf einem transparenten Substrat, so zum Beispiel auf einer Glasscheibe oder einer transparenten Schicht aus Kunststoff wie Polyethylenterephthalat (PET) befindet, eine Lochleitungsschicht (hole transport layer = HTL) vorgesehen sein, die aus den vernetzbaren Materialien bestehen und unterschiedlich dick sein kann. Zwischen der Anode und der Lochleitungsschicht kann abhängig von der Herstellungsmethode eine zusätzliche Lochleitungsschicht aus PEDOT/PSS (Poly(3,4-ethylendioxythiophen)/Polystyrolsulfonat, Baytron P) vorgesehen sein, die zur Absenkung der Injektionsbarriere für Löcher dient und außerdem die Oberfläche glättet. Auf die Lochleitungsschicht kann eine Schicht aufgebracht sein, die entweder verschiedenfarbig emittierende Farbstoffe enthält (vorzugsweise ca. 0,05-10 %, aber auch niedrigerer oder höhere Konzentrationen sind möglich, so zum Beispiel 0,01 bis 80%) beispielsweise ein weiß-emittierendes Copolymer oder aus mehreren unterschiedliche "Farben emittierenden Einzelschichten besteht. Geeignete Materialien sind aus den Druckschriften "J. Liu et al., Adv. Mater. 17, 2974-2978 (2005) " sowie "B.W. D'Andrade et al., Adv. Mater. 16, 624-628 (2004) " bekannt.

Diese Schicht ist die Emitterschicht (emitter layer = EL). Diese kann beispielsweise aus Lösung oder im Hochvakuum abgeschieden werden. Auf diese kann eine Elektronenleitungsschicht (electron transport layer = ETL) aufgebracht sein. Zum Abschluss kann eine Kathode (bestehend aus einem Metall oder Legierung mit geringer Elektronenaustrittsarbeit (z.B. Calcium, Aluminium, Magnesium/Silber-Legierung) vorgesehen sein, die beispielsweise im Hochvakuum aufgedampft wurde. Zur Verringerung der Injektionsbarriere für Elektronen kann zwischen Kathode und ETL oder Emitter eine sehr dünne Schicht an z.B. LiF oder CsF zum Beispiel aufgedampft worden sein. Die Kathode kann abschließend mit Silber oder mit Aluminium beschichtet sein. Das transparente Substrat kann aber auch an die Kathode grenzen. Die Kathode oder die Anode ist in Abhängigkeit vom Bedarf für Licht ganz oder teilweise transparent oder vollständig reflektierend.

In einer Ausführungsform der Erfindung umfasst der OLED-Aufbau mehrere dünne, organische Schichten, Insbesondere wird ein nicht transparentes Substrat (beispielsweise ein Silizium-Wafer oder eine Metallfolie) verwendet. Auf dieses wird in Abhängigkeit vom Bedarf eine ganz oder teilweise reflektierende oder ganz oder teilweise transparente Elektrode (z.B. aus ITO. Silber, Aluminium, Gold, MoO₃, Nickel, Calcium, Barium, LiF, CsF oder TiN) aufgebracht. Diese kann in Abhängigkeit vom Bedarf entweder als Anode oder als Kathode dienen. Zur Verbesserung der Lichtreflexion können zwischen die Anode und das Substrat weitere reflektierende Schichten (beispielsweise Bragg-Spiegel) eingefügt werden. Auf die organischen Schichten wird eine ganz oder teilweise transparente zweite Elektrode aufgebracht (z B. aus ITO, Silber, Aluminium, Gold, MoO₃, Nickel, Calcium, Barium, LiF, CsF oder TiN). Auf diese Elektrode können in Abhängigkeit vom Bedarf wiederum zusätzliche reflektierende Schichten (beispielsweise Bragg-Spiegel) aufgebracht werden. In dieser Ausführungsform wird das Licht nicht durch das Substrat, sondern durch die obere Elektrode (und die ggf. darüber liegenden, zusätzlichen, reflektierenden Schichten) abgestrahlt.

Der Erfindung liegt der Gedanke zugrunde, eine erste und zweite spiegelnde Schicht vorzusehen, die zugleich Elektrodenfunktionen übernehmen können, um das Bauteil geeignet ansteuern zu können. Zwischen den spiegelnden Schichten befindet sich eine Schicht, mit der insbesondere weißes Licht erzeugt wird. Zwischen den spiegelnden Schichten befindet sich eine Schicht, die vorgesehen wird, um geeignet strukturieren zu können. Es können darüber hinaus weitere Schichten innerhalb oder außerhalb des verlustbehafteten optischen Resonators vorgesehen werden. Wichtig ist lediglich, dass es eine Schicht im optischen Resonator gibt, die in nur einem Arbeitsschritt strukturiert worden ist. Die Reihenfolge der Aufbringung der gewünschten Schichten ist letzten Endes beliebig. Es kann also beispielsweise zuerst die strukturierte Schicht aufgebracht werden, dann eine Schicht, die weißes Licht emittiert und ggf. weitere, beispielsweise aus dem Stand der Technik bekannte Funktionsschichten.

Mit einem solchen Aufbau kann der mögliche Farbraum verbessert ausgenutzt bzw. erzeugt werden. Brillantere Farben und zwar nicht nur im Vergleich zur TFT- oder LCD-Technik, sondern auch im Vergleich zu anderen OLED-Beleuchtungselementen oder OLED-Displays sind daher möglich. Im Fall einer Weißlicht-Beleuchtung kann ein natürlicher wirkendes Spektrum erzeugt werden.

Wie aus dem Stand der Technik bekannt, kann ein Substrat, beispielsweise ein CMOS-Chip, bereits eine Elektronik umfassen, mit der im Fall eines Displays die Pixels entsprechend angesteuert werden. Die Strukturierung der Schicht mit den unterschiedlichen Schichtdicken muss dann so erfolgen, dass die entsprechenden Schichtdicken bzw. Pixel relativ zur Elektronik geeignet ausgerichtet werden. Es ist also im Fall eines Displays lediglich ein Ausrichtungsschritt erforderlich. Die weiteren aus dem Stand der Technik bekannten, eingangs genannten Ausrichtungsschritte entfallen.

In einer Ausführungsform der Erfindung umfasst die strukturierte Schicht der Leuchtdiode nicht lediglich drei unterschiedliche Dicken, um drei Grundfarben darzustellen, sondern wesentlich mehr unterschiedliche Dicken. Eine für die Herstellung eingesetzte Graustufenmaske weist dann nicht lediglich drei Graustufen zur Bereitstellung von drei Spektralfarben auf, sondern wesentlich mehr Farbniveaus, so beispielsweise zwanzig Abstufungen. Indem so viele verschiedene Farben von der Leuchtdiode emittiert werden, gelingt es sehr viel besser, eine gewünschten Lichtfarbe zu erzeugen, so zum Beispiel das Sonnenlicht nachzuahmen.

Aus Praktikabilitätsgründen können gemäß Stand der Technik nicht derart viele Abstufungen vorgesehen werden, die erforderlich sind, um perfektes weißes Licht zu erzeugen, also Licht, das eine gute Farbwiedergabe gewährleistet. Mit der vorliegenden Erfindung gelingt dies schnell und einfach, da eine Strukturierung in einem Arbeitsschritt bereitgestellt werden kann. Durch die vorliegende Erfindung wird es daher möglich, Beleuchtungskörper bereitzustellen, mit denen weißes Licht besonders gut nachgebildet wird.

Indem eine Schicht benötigt wird, die lediglich weißes Licht erzeugt, wird das Problem vermieden, dass sich unerwünschte Alterungserscheinungen aufgrund von unterschiedlicher Ansteuerung bemerkbar machen. Insofern gibt es einen Vorteil im Vergleich zu einem solchen Stand der Technik, bei dem verschiedenfarbig emittierende Pixel unterschiedlich und unterschiedlich lang angesteuert werden und die damit nachteilhaft unterschiedlich schnell altern.

In einer Ausführungsform der Erfindung nimmt die Dicke der strukturierten Schicht keilförmig zu bzw. ab. Der Abstand zwischen den beiden spiegelnden Flächen des Resonators verändert sich also keilförmig. Eine solche organische Leuchtdiode vermag das gesamte Farbspektrum darzustellen, wobei die einzelnen Spektralfarben räumlich geordnet aufgelöst sind.

in einer Ausführungsform der Erfindung sind unterschiedliche Bereiche des vorgenannten Keils durch unterschiedliche Elektroden kontaktiert. Es ist so eine getrennte Adressierung der verschiedenen Spektrallinienkomponenten möglich.

In einer Ausführungsform ist die erfindungsgemäße Leuchtdiode mit der keilförmigen Struktur Teil eines Spektrometers, also ein Bauteil, mit dem der Spektralbereich des Lichts räumlich nebeneinander abgebildet wird. Durch die keilförmige Struktur kann der gesamte Spektralbereich sehr gut wiedergegeben werden. Eine keilförmige Struktur im Sinne der Erfindung steigt von einer minimalen Dicke dₘᵢₙ kontinuierlich an, bis eine maximale Dicke dₘₐₓ der Struktur erreicht ist. Ein ähnliches Ergebnis kann erzielt werden, wenn anstelle eines kontinuierlichen Anstiegs der Anstieg treppenförmig erfolgt und die Treppe eine große Zahl an Stufen mit geringer Stufenhöhe umfasst. Je geringer die Stufenhöhe einer jeden Stufe ist, um so mehr wird ein Ergebnis erzielt, welches dem kontinuierlichen Anstieg entspricht. Zu bevorzugen ist allerdings der kontinuierliche Anstieg im Vergleich zu einem treppenförmigen Anstieg.

In einer Ausführungsform der Erfindung umfasst die erfindungsgemäße Leuchtdiode eine ansteigende und/ oder abfallende Struktur innerhalb des verlustbehafteten Resonators und wird als Beleuchtung eingesetzt. Die Beleuchtung strahlt verschiedene Lichtfarben aus, die voneinander räumlich getrennt sind.

Ein Bauteil, welches räumlich geordnet Spektralfarben wiederzugeben vermag, kann auch lediglich näherungsweise keilförmig im vorgenannten Sinne, so zum Beispiel treppenförmig sein. Allgemein ist ein solches Bauteil geeignet, um hieraus monochromatische integrierte Lichtquellen für die Sensorik zu fertigen.

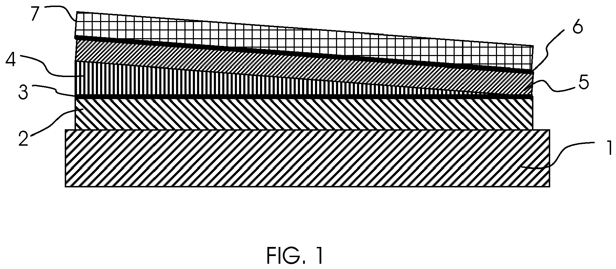

Figur 1 skizziert einen Aufbau eines Ausführungsbeispiels der Erfindung im Schnitt. Auf einem Silizium-Wafer 1 befindet sich eine 100 nm dicke, spiegelnde Schicht 2 aus Aluminium, die einerseits als Elektrode fungiert und andererseits als spiegelnde Schicht eines optischen Resonators. Auf der spiegelnden Schicht 2 befindet sich eine 10 nm dicke Schicht 3 aus MoO₃ sowie eine photochemisch vernetzbare, halbleitende Schicht 4, deren Dicke sich keilförmig verändert. Die dickste Stelle der keilförmigen Schicht 4 beträgt 60 nm. Die keilförmige Schicht besteht aus N,N'-bis[4-(6-[(3-ethyloxetan-3-yl)methoxy]hexyloxy)-phenyl]-N,N'-bis(4-methoxyphenyl)biphenyl-4,4'-diamine, also eine Struktur auf der Basis von Triarylamin mit Oxetan als reaktiver Gruppe. Auf der keilförmigen Schicht 4 ist eine Emitterschicht 5 abgeschieden, die weißes Licht zu emittieren vermag. Die Emitterschicht besteht aus einem weiß-emittierenden Copolymer und ist 70 nm dick. Auf der Emitterschicht 5 befindet sich eine Elektronen injizierende, 4 nm dicke Schicht 6 aus Barium sowie eine weitere spiegelnde Schicht 7, die aus Silber besteht und 70 nm dick ist. Die elektrisch leitfähige Schicht 7 ist teilweise transparent, so dass über diese Schicht 7 Licht aus dem optischen Resonator ausgekoppelt wird, der die beiden spiegelnden Schichten 2 und 7 umfasst.

Die Dicken der einzelnen Schichten sowie der Dickenbereich des Keils beginnend mit einer minimalen Dicke dₘᵢₙ = 0 und endend mit einer maximalen Dicke dₘₐₓ = 60 nm sind so gewählt, dass sich an der dünnsten Stelle des Keils für blaues Licht eine Resonanz ergibt und an der dicksten Stelle für rotes Licht. Soll ein anderer Spektralbereich abgedeckt werden, sind die genannten Dicken entsprechend anders zu wählen. Allein durch Wahl der Dicken kann also bereits ein gewünschter Spektralbereich eingestellt werden.

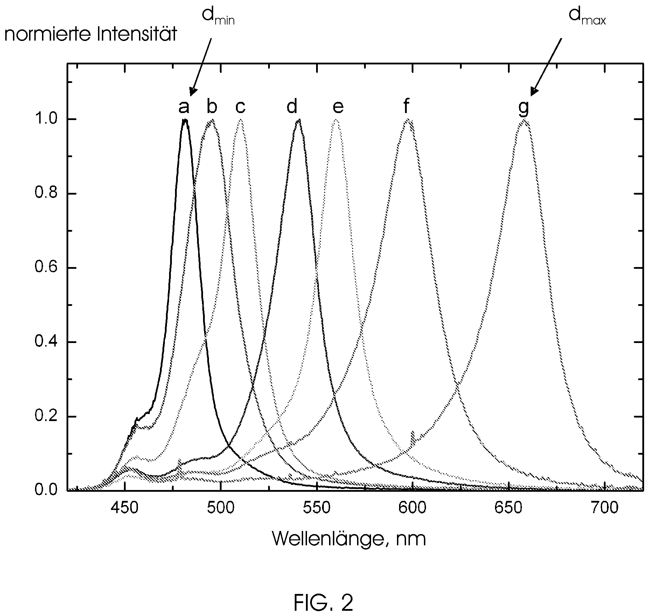

Mit der in Figur 1 gezeigten Lichtquelle konnten die in Figur 2 gezeigten Elektrolumineszenzspektren a bis g erzeugt werden. Dargestellt wird in Figur 2 die normierte Intensität "Normlized Intensity" gegen die Wellenlänge "Wavelength" in nm. Die einzelnen Lichtfarben können beispielsweise dazu verwendet werden, das Transmissionsspektrum einer Substanz, Flüssigkeit oder Lösung zu vermessen, in dem die OLED in geeigneter Weise mit einem Photodetektor kombiniert wird. Hierdurch wird die Funktionalität eines Spektrometers erhalten. Allerdings waren die Dimensionen des hergestellten Bauteils wesentlich kleiner als die Dimensionen eines handelsüblichen Spektrometers. Nach dem Stand der Technik ist eine solche Messung nicht möglich. Zum einen emittieren nach derzeitigem Stand der Technik hergestellte OLEDs über einen zu breiten Bereich des Spektrums (beispielsweise weiß-emittierende OLEDs, aber auch breitbandig rot, grün oder blau emittierende OLEDs). Zum anderen ist es nach dem Stand der Technik nicht möglich, auf einem einzigen Substrat, räumlich aufgelöst verschiedene Wellenlängen zu erzeugen, die den gesamten sichtbaren Bereich des Lichts abdecken.

Die spiegelnden Schichten in dem in Figur 1 gezeigten Ausführungsbeispiel müssen nicht notwendigerweise zugleich als Elektroden fungieren. Es genügt, wenn sich die Emitterschicht zwischen zwei als Elektrode fungierenden Schichten befindet. Die Schicht, deren Schichtdicke sich keilförmig ändert, muss also nicht zwingend innerhalb der zwei Elektroden angeordnet sein. Entsprechendes gilt für andere Ausführungsformen der Erfindung, die eine Schicht mit unterschiedlichen Schichtdicken umfassen. Ist die Schicht mit unterschiedlicher Schichtdicke bzw. keilförmiger Struktur zwar innerhalb des optischen Resonators, aber nicht zwischen zwei Elektroden angeordnet, so kann das Material freier gewählt werden, da es dann nicht darauf ankommt, inwiefern die Schicht mit unterschiedlichen Schichtdicken elektrisch leitfähig ist oder nicht. Diese Schicht mit unterschiedlichen Schichtdicken kann dann also ein optisch transparenter, elektrischer Isolator sein.

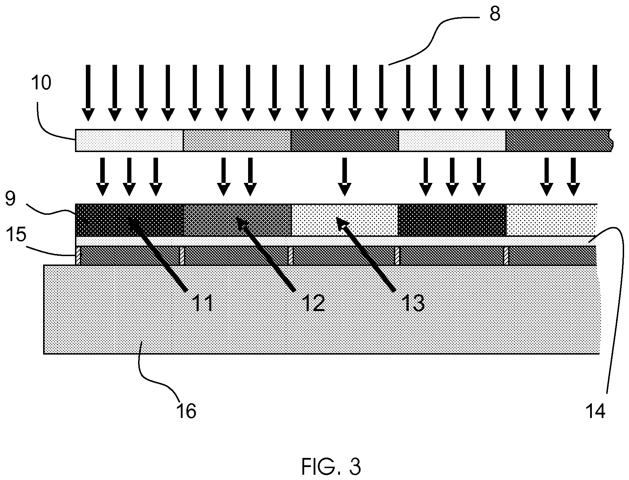

Figur 3 skizziert die Belichtung 8 eines vernetzbaren Halbleiters 9 durch Graustufenmaske 10. Unterschiedliche Belichtungsdosen bewirken unterschiedliche Vernetzungsgrade in den Bereichen 11, 12 und 13. Der vernetzbare Halbleiter, beispielsweise bestehend aus N,N'-bis(4-(6-((3-ethyloxetan-3-y)methoxy))-hexylpenyl)-N,N'-diphenyl-4,4'-diamin oder aber N,N'-bis[4-(6-[(3-ethyloxetan-3-yl)methoxy]hexyloxy)-phenyl]-N,N'-bis(4-methoxyphenyl)biphenyl-4,4'-diamine befindet sich auf einem transparenten Oxid 14, so zum Beispiel auf MoO₃. Das transparente Oxid ist auf einem aus Metall bestehenden pixilierten Spiegel 15 aufgebracht. Der Spiegel kann beispielsweise aus Aluminium bestehen. Der Spiegel 15 wiederum befindet sich auf einem Substrat 16, das beispielsweise aus Siliziumdioxid und/ oder Silizium besteht und bereits eine Elektronik umfassen kann, mit der die Pixels entsprechend angesteuert werden.

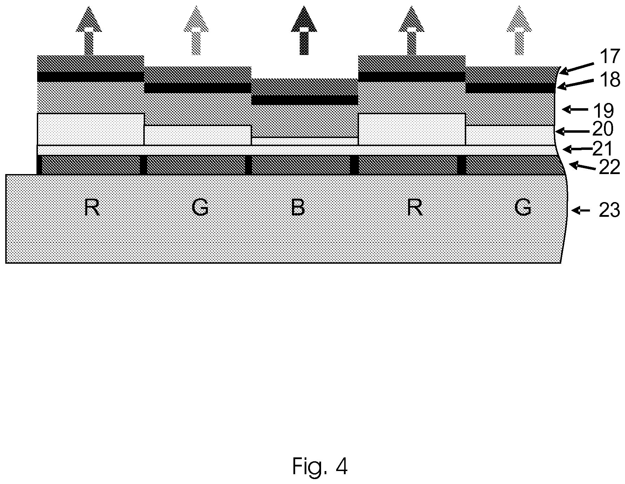

Figur 4 zeigt ein schematisches Querschnittsbild durch ein mit der vorliegenden Erfindung hergestelltes Displays mit rotem (R), grünen (G) und blauen (B) Subpixeln. Gezeigt wird der folgende Schichtaufbau:
17: Teilweise transparenter Metall-Spiegel, z.B. Ag;
18: Elektroneninjektions-Schicht, z.B. Ba ;
19: Emitterschicht
20: vernetzter Halbleiter;
21: Transparentes Oxid, z.B. MoO₃;
22: Pixilierter Metall-Spiegel, z.B. Al;
23: Substrat.

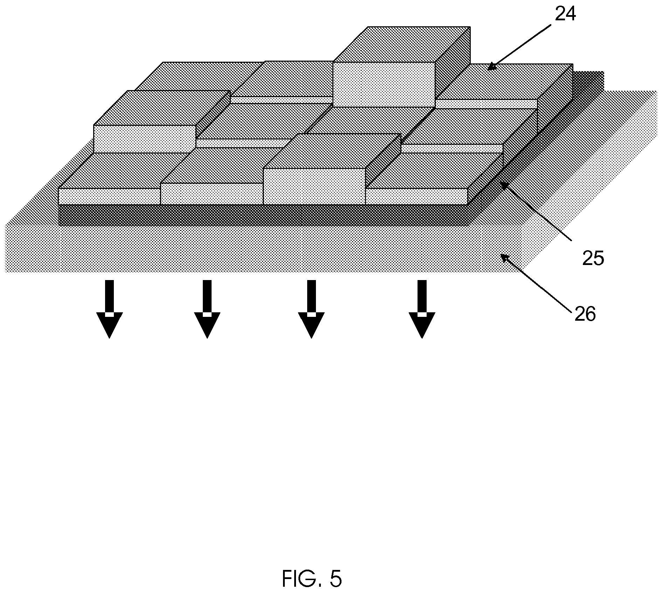

Figur 5 zeigt einen schematischen Aufbau einer mit der vorliegenden Erfindung hergestellten Lichtquelle für Beleuchtungsanwendungen. Gezeigt ist das Bauteil vor der Deposition der Emitterschicht, der Elektroneninjektionsschicht und der reflektierenden Kathode. Dargestellt werden vernetzte Lochleiterschichten 24 verschiedener Dicke, ein teilweise transparenter Metall-Spiegel 25, z.B. bestehend aus Ag sowie ein transparentes Substrat 26.

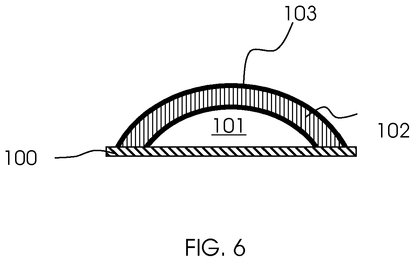

Figur 6 zeigt ein Beispiel für ein Beleuchtungselement, welches das Farbspektrum räumlich getrennt emittiert. Auf einer spiegelnden Schicht 100 befindet sich eine optisch transparente, halbkugelförmige Schicht 101, die also sowohl kontinuierlich ansteigt als auch wieder abfällt. Auf der halbkugeligen Schicht 101 befindet sich ein üblicher OLED-Aufbau 102 umfassend zwei Elektroden und eine dazwischen liegende Emitterschicht. Das aus der Emitterschicht stammende Licht wird zwischen der spiegelnden Schicht 100 und einer entgegengesetzt liegenden, äußeren, teilweise spiegelnden Schicht 103 in der Regel ein oder mehrmals hin- und her reflektiert, bevor das Licht durch die Schicht 103 hindurch austritt. Die Schicht 103 fungiert zugleich als Elektrode.

## Patentansprüche

1. Organische Leuchtdiode mit einem verlustbehafteten optischen Resonator und einer Emitterschicht (5) im optischen Resonator, die durch Rekombination von Elektronen mit Löchern Licht erzeugen kann, wobei die Leuchtdiode ein innerhalb des Resonators angeordnetes, fotolithographisch strukturierbares Material umfasst, wobei das Material insbesondere photchemisch vernetzbar oder ein Photolack ist, der durch Belichtung löslich wird, wobei das fotolithographisch strukturierbare Material in Form einer Schicht (4) mit unterschiedlichen Schichtdicken vorliegt, sodass eine Vielzahl von Farben erzeugt werden können, wobei die Emitterschicht (5) so beschaffen ist, dass diese weißes Licht zu emittieren vermag, **dadurch gekennzeichnet, dass** die Schicht (4) mit unterschiedlichen Schichtdicken aus einem Material mit einer Struktur auf der Basis von Triarylamin mit Oxetan als reaktiver Gruppe besteht und eine lochleitende Schicht (4) zusätzlich zur Emitterschicht (5) ist.

2. Leuchtdiode nach dem vorhergehenden Anspruch, bei der die Emitterschicht ein RGB-Copolymer, eine Mischung aus rot, grün und blau emittierenden Komponenten oder ein Schichtsystem ist oder aufweist, welches rot, grün und blau emittierende Schichten umfasst.

3. Leuchtdiode nach einem der vorhergehenden Ansprüche, bei der ganz oder teilweise spiegelnde Schichten (2, 7) des optischen Resonators aus Silber, Aluminium oder Gold bestehen oder als Bragg-Spiegel ausgeführt sind.

4. Leuchtdiode nach einem der vorhergehenden Ansprüche, bei der eine Elektronen- oder Loch-leitende Schicht (4) aus einem photochemisch vernetzbarem Material besteht und diese Schicht unterschiedlich dick ist.

5. Leuchtdiode nach einem der vorhergehenden Ansprüche mit einer Schicht (4) innerhalb eines verlustbehafteten optischen Resonators, deren Schichtdicke sich gemäß einem keilförmigen oder treppenförmigen Verlauf ändert.

6. Leuchtdiode nach einem der vorhergehenden Ansprüche mit einer Schicht innerhalb eines verlustbehafteten optischen Resonators, deren Schicht mehr als drei verschiedene Schichtdicken, vorzugsweise wenigstens sechs verschiedene, besonders bevorzugt zehn verschiedene Schichtdicken umfasst.

7. Display mit Leuchtdioden nach einem der vorhergehenden Ansprüche mit einer Schicht, die drei unterschiedliche Schichtdicken umfasst.

8. Beleuchtung mit Leuchtdioden nach einem der vorhergehenden Ansprüche mit einer Schicht (4) innerhalb eines verlustbehafteten optischen Resonators, deren Schichtdicke kontinuierlich ansteigt und/ oder abfällt.

9. Verfahren zur Herstellung einer Leuchtdiode nach einem der vorhergehenden Ansprüche, welches umfasst, dass oberhalb einer spiegelnden Schicht (2) eines verlustbehafteten optischen Resonators eine so beschaffene Emitterschicht (5), dass diese weißes Licht zu emittieren vermag, sowie eine elektrisch leitende oder elektrisch halbleitende Schicht (4) aus photochemisch vernetzbarem Material aufgebracht wird und unterschiedliche Schichtdicken der elektrisch leitenden oder elektrisch halbleitenden Schicht (4) durch ein fotolithografisches Verfahren eingestellt werden, und oberhalb dieser Schichten (4,5) eine zweite spiegelnde Schicht (7) des verlustbehafteten optischen Resonators aufgebracht wird, **dadurch gekennzeichnet, dass** die Schicht (4) mit unterschiedlichen Schichtdicken aus einem Material mit einer Struktur auf Basis von Triarylamin mit Oxetan als reaktiver Gruppe besteht und eine lochleitende Schicht (4) zusätzlich zur Emitterschicht (5) ist.

10. Verfahren nach dem vorhergehenden Anspruch, bei dem das lithografische Verfahren durchgeführt wird, indem eine Graustufenmaske auf das photochemisch vernetzbare Material gelegt, das photochemisch vernetzbare Material durch die Graustufenmaske hindurch belichtet wird und anschließend die nicht vernetzten Bereiche entfernt werden.

## Claims

1. Organic light-emitting diode having a lossy optical resonator and an emitter layer (5) in the optical resonator which can generate light by recombination of electrons with holes, the light-emitting diode comprising a photolithographically patternable material arranged within the resonator, the material being in particular photochemically crosslinkable or a photoresist which becomes soluble by exposure to light, wherein the photolithographically patternable material is present in the form of a layer (4) with different layer thicknesses so that a plurality of colours can be produced, the emitter layer (5) being adapted such that it is capable of emitting white light, **characterised in that** the layer (4) with different layer thicknesses is made of a material with a structure based on triarylamine with oxetane as reactive group and is a hole-conducting layer (4) in addition to the emitter layer (5)

2. Light-emitting diode according to the preceding claim, wherein the emitter layer is or comprises an RGB copolymer, a mixture of red, green and blue emitting components or a layer system comprising red, green and blue emitting layers.

3. Light-emitting diode according to one of the preceding claims, in which fully or partially reflecting layers (2, 7) of the optical resonator are made of silver, aluminium or gold or are implemented as Bragg mirrors.

4. Light-emitting diode according to one of the preceding claims, in which an electron or hole conducting layer (4) is made of a photochemically crosslinkable material and said layer is of different thickness.

5. Light-emitting diode according to one of the preceding claims with a layer (4) within a lossy optical resonator, the layer thickness of which changes according to a wedge-shaped or step-shaped course.

6. Light-emitting diode according to one of the preceding claims with a layer within a lossy optical resonator, the layer of which comprises more than three different layer thicknesses, preferably at least six different, particularly preferably ten different layer thicknesses.

7. Display with light-emitting diodes according to any of the preceding claims with a layer comprising three different thicknesses.

8. Lighting with light-emitting diodes according to one of the preceding claims with a layer (4) inside a lossy optical resonator, the layer thickness of which increases and/or decreases continuously.

9. Method for producing a light-emitting diode according to one of the preceding claims, which comprises applying above a reflecting layer (2) of a lossy optical resonator an emitter layer (5) which is adapted such that it is capable of emitting white light, and an electrically conductive or electrically semiconductive layer (4) of photochemically crosslinkable material, and adjusting different layer thicknesses of the electrically conductive or electrically semiconductive layer (4) by a photolithographic process, and applying a second reflective layer (7) of the lossy optical resonator above said layers (4, 5), **characterised in that** the layer (4) with different layer thicknesses is made of a material with a structure based on triarylamine with oxetane as reactive group and is a hole-conducting layer (4) in addition to the emitter layer (5).

10. Method according to the preceding claim in which the lithographic process is carried out by placing a grey scale mask on the photochemically crosslinkable material, exposing the photochemically crosslinkable material through the grey scale mask and subsequently removing the non-crosslinked areas.

## Revendications

1. Diode électroluminescente organique comprenant un résonateur optique présentant des pertes et une couche formant émetteur (5) dans le résonateur optique, laquelle peut générer de la lumière par la recombinaison d'électrons avec des trous, la diode électroluminescente comprenant un matériau structurable de manière photolithographique et disposé à l'intérieur du résonateur, le matériau étant notamment réticulable photochimiquement ou étant un photorésist, qui devient soluble par exposition, dans lequel le matériau structurable de manière photolithographique est présent sous forme d'une couche (4) ayant des épaisseurs de couche différentes, de sorte qu'une pluralité de couleurs peut être générée, la couche formant émetteur (5) étant conçue de sorte qu'elle est capable d'émettre de la lumière blanche, **caractérisée en ce que** la couche (4) ayant des épaisseurs de couche différentes est composée d'un matériau comprenant une structure sur la base de triarylamine avec oxétane comme groupe réactif et elle est une couche transportant des trous (4) en outre de la couche formant émetteur (5).

2. Diode électroluminescente selon la revendication précédente, dans laquelle la couche formant émetteur est ou comprend un copolymère RGB, un mélange de composants émettant de la lumière rouge, verte et bleue ou un système de couches, qui comprend des couches émettant de la lumière rouge, verte et bleue.

3. Diode électroluminescente selon l'une des revendications précédentes, dans laquelle des couches (2, 7) complètement ou partiellement réfléchissantes du résonateur optique sont fabriquées en argent, en aluminium ou en or ou sont configurées comme réseau de Bragg.

4. Diode électroluminescente selon l'une des revendications précédentes, dans laquelle une couche (4) transportant des électrons ou des trous consiste en un matériau réticulable photochimiquement et cette couche comprend des épaisseurs différentes.

5. Diode électroluminescente selon l'une des revendications précédentes, comprenant une couche (4) à l'intérieur d'un résonateur optique présentant des pertes, l'épaisseur de la couche changeant selon une évolution en forme de coin ou en forme d'escalier.

6. Diode électroluminescente selon l'une des revendications précédentes, comprenant une couche à l'intérieur d'un résonateur optique présentant des pertes, la couche comprenant plus de trois épaisseurs de couche différentes, de préférence au moins six épaisseurs de couche différentes, de préférence particulière dix épaisseurs de couche différentes.

7. Ecran comprenant des diodes électroluminescentes selon l'une des revendications précédentes, comprenant une couche, qui comprend trois épaisseurs de couche différentes.

8. Eclairage comprenant des diodes électroluminescentes selon l'une des revendications précédentes, comprenant une couche (4) à l'intérieur d'un résonateur optique présentant des pertes, laquelle couche a une épaisseur de couche, qui augmente et/ou diminue de manière continue.

9. Procédé de fabrication d'une diode électroluminescente selon l'une des revendications précédentes, lequel comprend l'étape où on applique une couche formant émetteur (5) et conçue de sorte que celle-ci est capable d'émettre de la lumière blanche, ainsi qu'une couche électriquement conductrice ou électriquement semi-conductrice (4) composée d'un matériau réticulable photochimiquement au-dessus d'une couche réfléchissante (2) d'un résonateur optique présentant des pertes, et on fixe des épaisseurs de couche différentes de la couche électriquement conductrice ou électriquement semi-conductrice (4) par moyen d'un procédé photolithographique, et au-dessus de ces couches (4, 5), on applique une deuxième couche réfléchissante (7) du résonateur optique présentant des pertes, **caractérisé en ce que** la couche (4) ayant des épaisseurs de couche différentes est composée d'un matériau comprenant une structure sur la base de triarylamine avec oxétane comme groupe réactif et elle est une couche transportant des trous (4) en outre de la couche formant émetteur (5).

10. Procédé selon la revendication précédente, dans lequel le procédé lithographique est effectué en ce qu'on place un masque de niveaux de gris sur le matériau réticulable photochimiquement, on expose le matériau réticulable photochimiquement à travers le masque de niveaux de gris et ensuite on enlève les zones non réticulées.
